# EUROPÄISCHE PATENTANMELDUNG

(11) **EP 2 078 694 A2**
(43) Veröffentlichungstag der Anmeldung: **15.07.2009**
(21) Anmeldenummer: 08105987.5
(22) Anmeldetag: 16.12.2008
(51) Int. Cl.: B81C 1/00

(54) **Schutzsystem und Verfahren zur Vereinzelung von MEMS-Strukturen**

(30) Priorität: 08.01.2008 DE 102008003452
(71) Anmelder: ROBERT BOSCH GMBH, 70442 Stuttgart (DE)
(72) Erfinder: Teeffelen, Kathrin, 70569, Stuttgart (DE); Feyh, Ando, 71732, Tamm (DE); Leinenbach, Christina, 66806, Ensdorf (DE)

(57) **Zusammenfassung**

Die Erfindung betrifft ein Schutzsystem für MEMS-Strukturen, mit einer fragilen offenen Struktur (12) und einer optionalen Opferschicht (13), aufgebracht auf einem Wafer (14), bei dem eine Schutzschicht (10) auf der Vorderseite der Struktur (12) aufgebracht ist, wobei die Schutzschicht (10) rückstandsfrei entfernbar ist, sowie ein Verfahren zur Vereinzelung von fragilen offenen MEMS-Strukturen.

## Beschreibung

Die Erfindung betrifft ein Schutzsystem zur Vereinzelung von MEMS-Strukturen, sowie ein Verfahren, mit dessen Hilfe die Vereinzelung fragiler offener Sensoren, insbesondere in mikromechanischen Bauteilen, vereinfacht werden kann.

### Stand der Technik

Mikromechanische Strukturen (MEMS) werden mit Methoden der Mikrotechnik hergestellt und weisen eine hohe Präzision auf. Sie dienen entweder als Haltestrukturen zur Aufnahme miniaturisierter Bauteile oder werden als bewegliche Elemente realisiert zum Beispiel in Form von Zungen oder Fingern, schwingenden Strukturen, oder Mikromotoren, mithilfe der Bulk- oder Oberflächenmikromechanik. Beispiele für mikromechanische Systeme, welche industriell gefertigt werden, sind: Beschleunigungssensoren, Drehratensensoren, elektrostatische und elektromagnetische Linearantriebe (Mikroaktoren), Mikromotoren, Zahnräder für Mikrogetriebe, kapazitive Mikrophone, Greiferstrukturen, bimorphe Strukturen zur Temperaturmessung oder piezoelektrische Schichtstrukturen zur Dehnungs- oder Spannungsmessung. Mikromechanische Strukturen können darüber hinaus zusammen mit der mikroelektronischen Schaltung auf einem Substrat gefertigt werden. Solch ein integrierter Aufbau vermindert die Fertigungskosten und verringert die Störanfälligkeit. In der industriellen Fertigung solcher Systeme spielt der Schritt der Vereinzelung der durch Strukturierung in zusammenhängender Reihe hergestellten MEMS-Strukturen eine große Rolle. Im Allgemeinen erfolgt die Vereinzelung derzeit durch Sägen mit einer wassergekühlten Kreissäge.

So ist aus der DE 10 2005 004 877 A1 ein Herstellungsverfahren für ein mikromechanisches Bauelement zu entnehmen, das gerade für fragile mikromechanische Strukturen geeignet ist. Dieses Bauelement kann durch Sägen mit Wasserkühlung vereinzelt werden.

Dieses Verfahren kommt für kapazitive MEMS-Bauteile mit fragiler Membran oder fragilen Kammstrukturen und Öffnungen in der Sensorvorder- und -rückseite jedoch nicht in Frage. Die fragilen mikromechanischen Strukturen müssten dabei von einer auf den Sensor gebondeten Siliziumkappe geschützt werden, so dass während des Sägens weder das Wasser, welches das Sägeblatt kühlt und den Sägeschlamm fortspült, noch der Wasserdruck an die mikromechanischen Strukturen gelangen und diese schädigen können. Das Aufbringen einer solchen Schutzkappe aus Silizium ist für die beschriebenen offenen fragilen Strukturen nicht möglich. Ein Loch für den Schalleintritt in der Schutzkappe würde im Unkehrschluss wiederum zu einem Wassereinbruch führen. Der Wasserdruck würde die fragilen Strukturen zerstören und könnte zudem hier zu Sticking führen.

Es gibt darüber hinaus relativ kostenintensive Vereinzelungsprozesse für derartig aufgebaute Sensoren, beispielsweise das sogenannte Mahoh-Dicing der Firma Accretech. Es erzeugt über Laserfocussierung eine Sollbruchstelle im Material, entlang derer der Wafer anschließend in seine Einzelchips zerbrochen wird. Dieses Verfahren bringt jedoch relativ hohe Investitionskosten mit sich.

Es ist die Aufgabe der Erfindung ein Schutzsystem sowie ein Verfahren zur Vereinzelung insbesondere von fragilen offenen MEMS-Strukturen zu schaffen, das mit vorhandenem Equipment, wie zum Beispiel klassische Wafersägen und Lithographie-Equipment, ausgeführt werden kann.

### Offenbarung der Erfindung

Die Lösung der Aufgabe erfolgt erfindungsgemäß durch ein Schutzsystem mit den Merkmalen des Anspruchs 1 sowie ein Verfahren zur Vereinzelung insbesondere von fragilen offenen MEMS-Strukturen mit den Merkmalen des Anspruchs 10. Vorteilhafte Ausgestaltungen der Erfindung sind in den Unteransprüchen angegeben.

Das erfindungsgemäße Schutzsystem für MEMS-Strukturen umfasst eine fragile offene Struktur und eine optionale Opferschicht, aufgebracht auf einem Wafer, wobei eine Schutzschicht auf der Vorderseite der Struktur aufgebracht ist, die rückstandsfrei entfernbar ist.

Unter dem Begriff offene fragile Struktur werden im Rahmen der vorliegenden Erfindung sowohl Membranen als auch Kammstrukturen, Fingerstrukturen, Balkenstrukturen und ähnliche Strukturen verstanden, wobei eine Membran als offene fragile Struktur besonders bevorzugt ist. Sie können erfindungsgemäß bevorzugt aus Silizium bestehen, gleichermaßen sind jedoch auch andere geeignete Materialien möglich.

Erfindungsgemäß ist es erstmals möglich, eine Schutzschicht auf MEMS-Strukturen aufzubringen, die nach dem Herstellungsprozess und insbesondere nach dem Vereinzelungsschritt ohne Rückstände wieder entfernt werden kann. So gelingt der Schutz der fragilen MEMS-Strukturen vor Wasser während des Sägevorgangs, was andernfalls unerwünschtes Sticking verursachen würde. Daneben wird durch die Schutzschicht auch ein mechanischer Schutz der Strukturen vor dem anstehenden Wasserstrahl und während der intermediär vorgenommenen Prozessschritte erreicht. Auch bei nicht Wasser-unterstützten Vereinzelungsverfahren, die allesamt Material abtragend sind, wie beispielsweise beim Laserschneiden, kann ein Schutz der fragilen Strukturen vor den anfallenden Materialauswürfen mit der Schutzschicht erzielt werden. Damit kann erstmals ein Schutzsystem zur Verfügung gestellt werden, das ausschließlich die Verwendung von in der Mikromechanik etablierten Serienprozessen mit konventionellen Anlagen auch für fragile, offene MEMS-Strukturen erlaubt.
Ein weiterer Vorteil liegt darin, dass das erfindungsgemäße Schutzsystem im Vergleich zu den bekannten Schutzkappen aus Silizium deutlich kostengünstiger in der Herstellung und Verarbeitung ist und zudem ein vereinfachtes Aufbringen auf die fragilen Strukturen ermöglicht. Auf aufwendige Folienprozesse zum Schutz des mikromechanischen Bauteils, zum Beispiel bei empfindlichen Membranen, kann zudem verzichtet werden.

Vorzugsweise umfasst die Schutzschicht ein Polymer, das thermisch und/oder mittels Strahlung zersetzbar ist. Als spezielle Form der Strahlung kann auch ein Plasmaprozess verwendet werden.
Beispielsweise können Polynorbornen oder Polycarbonat als zersetzbare Polymere eingesetzt werden.

Auf diese Weise können weitere übliche Reinigungsprozesse nach dem wassergekühlten Sägen mit Flüssigkeiten und/oder Luft kombiniert mit Wasserdruck vermieden werden. Bevorzugt werden solche Polymere ausgewählt, deren Zersetzungstemperatur kompatibel ist zu den IC-Bauteilen, wodurch eine gute Integrationsfähigkeit sicher gestellt wird.

Die Erfindung betrifft ferner ein Verfahren zur Prozessierung von fragilen offenen MEMS-Strukturen, gekennzeichnet durch die Schritte
a) Aufbringen einer Schutzschicht auf die Vorderseite einer fragilen offenen Struktur,
b) Durchführung von Rückseitenprozessen,
c) gegebenenfalls Ätzen einer optionalen Opferschicht und Freistellen der Struktur von der Rückseite her, und
d) rückstandsfreies Entfernen der Schutzschicht.

Als Rückseitenprozesse können beispielsweise Plasma-Ätzschritte oder Lithographieprozesse im Rahmen des erfindungsgemäßen Verfahrens ausgeführt werden.

In einer bevorzugten Ausgestaltung des erfindungsgemäßen Verfahrens Verfahren können nach Schritt c) als weitere Schritte
e) Aufbringen eines Wafers auf eine Sägefolie, und
f) Sägen des Wafers von der Vorderseite,
ausgeführt werden.

Die Schutzschicht kann vorzugsweise durch Aufschleudern eines flüssigen, thermisch und/oder mittels Strahlung zersetzbaren Polymers aufgebracht werden, wobei als spezielle Form der Strahlung zur Zersetzung auch ein Plasmaprozess verwendet werden kann.

In einer bevorzugten Ausgestaltung des erfindungsgemäßen Verfahrens kann die Schutzschicht bei Temperaturen zwischen 80°C und 450°C, bevorzugt bei Temperaturen zwischen 100°C und 250°C, rückstandsfrei entfernt werden.

Bevorzugt werden entsprechende, in der Literatur bekannte Polymere eingesetzt, die typischerweise bei Temperaturen um 200-400°C zersetzt werden können. Besonders vorteilhaft kann die Zersetzung durch Bestrahlung beispielsweise mit UV-Licht unterstützt werden, so dass eine Zersetzungstemperatur von um etwa 100°C erreicht werden kann. Bei dieser Verfahrensweise wird die Sägefolie, welche sich auf der Sensor-Rückseite befindet, nicht beschädigt, so dass sie weiterhin als Träger für die nun vereinzelten MEMS-Strukturen dienen kann.

In einer weiteren Ausführugsform des erfindungsgemäßen Verfahrens können als Plasma-Rückseiten-Prozesse Tieftrench und/oder Oxidöffnen durchgeführt werden.

Daran kann sich bevorzugt ein Ätzen einer optionalen Opferschicht und Freistellen der Membran anschließen. Bevorzugt kann die Opferschicht eine SiGe- oder Oxid-Schicht sein und die SiGe-Schicht mit CLF₃-Gas und die Oxid-Schicht mit HF-Dampf geätzt werden.

Die Schutzschicht kann vorteilhafterweise bei allen genannten Prozessschritten einen chemischen und mechanischen Schutz für die fragile Struktur gewährleisten und die Struktur stabilisieren.

Gemäß einer weiteren bevorzugten Ausgestaltung des erfindungsgemäßen Verfahrens kann die Sägefolie im Anschluss an Schritt f) expandiert werden. Dadurch wird der Abstand zwischen den nun vereinzelten Bauteilen vergrößert und die Einzelstrukturen können zum Beispiel mit Pick-and-Place-Tools von der Folie abgepickt und verpackt werden.

Bevorzugt wird ein erfindungsgemäßes Schutzsystems für die Herstellung mikromechanischer Bauteile mit fragilen offenen MEMS-Strukturen, insbesondere zur Herstellung kapazitiver Mikrophone, verwendet.

### Zeichnungen

Nachfolgend wird die Erfindung unter Bezugnahme auf die anliegenden Zeichnungen anhand eines bevorzugten Ausführungsbeispiels näher erläutert.
Es zeigen:
- Fig. 1:: eine schematische Querschnittsansicht des erfindungsgemäßen Schutzsystems im Ausgangszustand, bei dem sich die Schutzschicht bereits auf der Sensor-Vorderseite befindet,
- Fig. 2:: eine schematische Querschnittsansicht des erfindungsgemäßen Schutzsystems aus Fig. 1 nach Durchführung der Rückseitenprozesse,
- Fig. 3:: eine schematische Querschnittsansicht des erfindungsgemäßen Schutzsystems aus Fig. 2 nach der Opferschichtätzung,
- Fig. 4:: eine schematische Querschnittsansicht des erfindungsgemäßen Schutzsystems aus Fig. 3 als Verbund nach Durchführung der Opferschichtätzung,
- Fig. 5:: eine schematische Querschnittsansicht des erfindungsgemäßen Schutzsystems aus Fig. 4 nach Aufbringen der Sägefolie auf die Sensor-Rückseite,
- Fig. 6:: eine schematische Querschnittsansicht des erfindungsgemäßen Schutzsystems aus Fig. 5 nach Durchführung der Vereinzelung, und
- Fig. 7:: eine schematische Querschnittsansicht des erfindungsgemäßen Schutzsystems aus Fig. 6 nach dem rückstandsfreien entfernen der Schutzschicht.

### Beschreibung der Ausführungsbeispiele

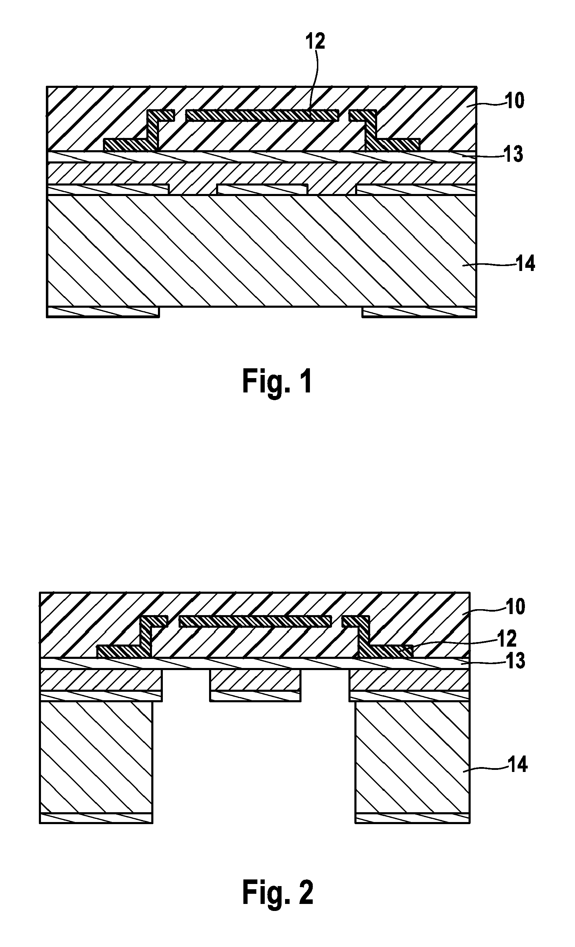

Fig. 1 zeigt in einer schematischen Querschnittsansicht des erfindungsgemäßen Schutzsystems den Ausgangszustand für eine Herstellung von fragilen, offenen MEMS-Strukturen. Die rückstandsfrei entfernbare Schutzschicht 10 ist direkt auf der Vorderseite der fragilen, offenen Struktur 12 aufgebracht. Das hier abgebildete Beispiel eines Membransensors umfasst weiterhin eine optionale Opferschicht 13 beispielsweise aus einem Oxid oder aus SiGe, die zwischen der Membran 12 und dem Wafer 14 plaziert ist.
Das als Schutzschicht 10 eingesetzte rückstandfrei zersetzbare Polymer wird zum Schutz auf die fragilen Strukturen 12 aufgebracht. Das erfolgt im Fall des kapazitiven Mikrofons in einem Prozesszustand, in dem das Bauteil vorder- und rückseitig noch vollständig geschlossen ist und keine Gräben oder Löcher aufweist. Das Polymer wird auf die Membran 12, die zu diesem Zeitpunkt noch durch die Opferschicht 13 stabilisiert ist, auf die Sensorvorderseite aufgebracht. Das kann bevorzugt durch Aufschleudern des flüssigen Polymers erfolgen, wie es zum Beispiel für das Aufbringen von Fotolacken auf Wafer in der Mikromechanik verwendet wird. In diesem Bauteil-Zustand kann beim Aufbringen des Polymers dieses nicht durch die Öffnungen der Membran in den Spalt zwischen den beiden Elektroden gelangen, da sich zu diesem Zeitpunkt noch die Opferschicht im Sensor befindet.

Fig. 2 zeigt eine schematische Querschnittsansicht des erfindungsgemäßen Schutzsystems aus Fig. 1 nach Durchführung der Rückseitenprozesse.
Beispiele geeigneter Rückseitenprozesse sind Tieftrench-Ätzen und Oxidöffnen, die unter anderem in der DE 10 2005 004 877 A1 und der DE 42 41 045 C2 näher beschrieben und dem Fachmann bekannt sind.

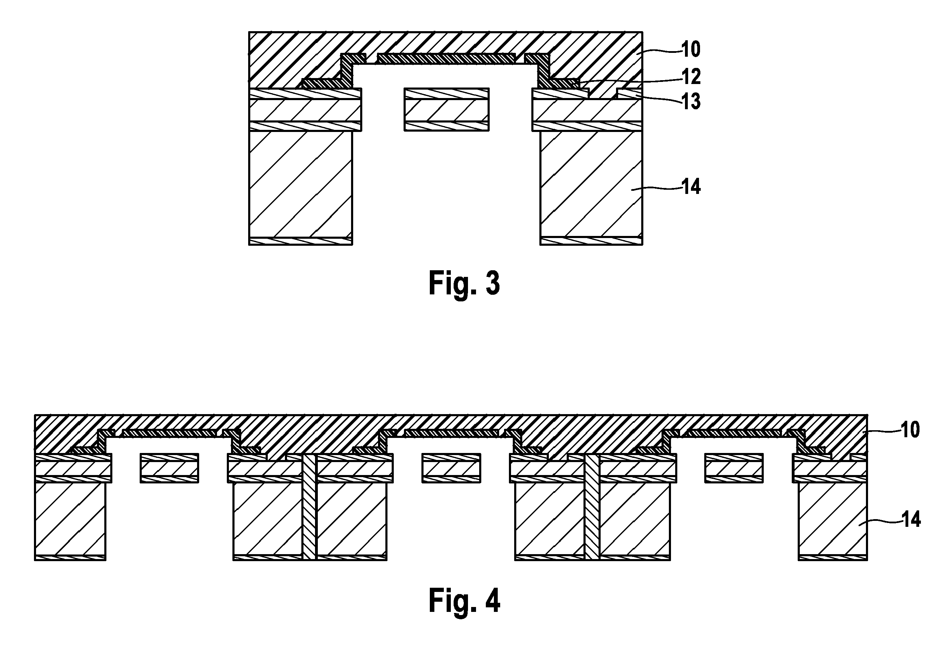

Fig. 3 zeigt eine schematische Querschnittsansicht des erfindungsgemäßen Schutzsystems aus Fig. 2 nach der Opferschichtätzung.
Der Opferschichtprozess stellt die Membran 12 frei. Abhängig von der Art der Opferschicht 13 kann ein Ätzen zum Beispiel mit ClF₃-Gas im Fall einer SiGe-Opferschicht oder HF-Dampf im Fall einer oxidischen Opferschicht eingesetzt werden.
Das Bauteil hat nun alle Fertigungsprozesse, die auf Waferebene stattfinden, durchlaufen. Die Membran 12 ist nur noch mit der polymeren Schutzschicht 10 bedeckt, welche erst im vereinzelten Zustand entfernt wird.

Fig. 4 zeigt daher eine schematische Querschnittsansicht des erfindungsgemäßen Schutzsystems aus Fig. 3 als Verbund nach Durchführung der Opferschichtätzung.

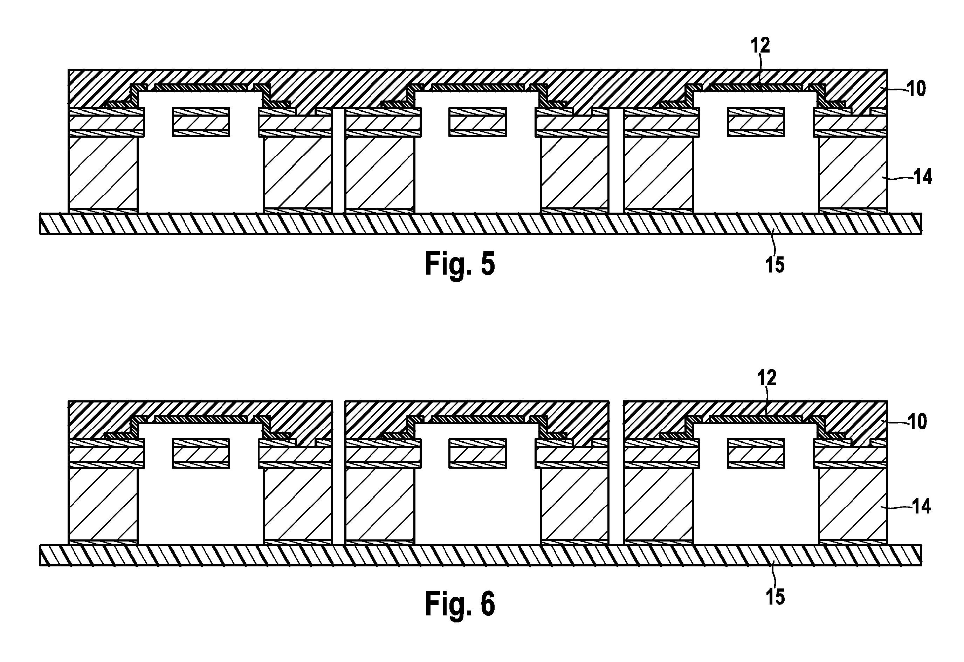

Fig. 5 zeigt eine schematische Querschnittsansicht des erfindungsgemäßen Schutzsystems aus Fig. 4 nach Aufbringen der Sägefolie 15 auf die Sensor-Rückseite.
Es kann eine Sägefolie 15 verwendet werden, wie sie standardmäßig für das Sägen von Wafern 14 eingesetzt wird. Auch bei dem Schritt des Auflaminierens der Sägefolie 15 wird die Membran 12 durch die Schutzschicht 10 geschützt und stabilisiert.

Fig. 6 zeigt eine schematische Querschnittsansicht des erfindungsgemäßen Schutzsystems aus Fig. 5 nach Durchführung der Vereinzelung.
Die Vereinzelung kann bevorzugt mittels Sägen von der Vorderseite vorgenommen werden. Gleichermaßen ist eine andere materialbatragende Vereinzelung, beispielsweise mittels Laserschneiden, möglich. Die Membran 12 ist während des Sägevorgangs durch die Schutzschicht 10 vor Wassereindringen und vor dem mechanischen Wasserdruck des Strahls geschützt.

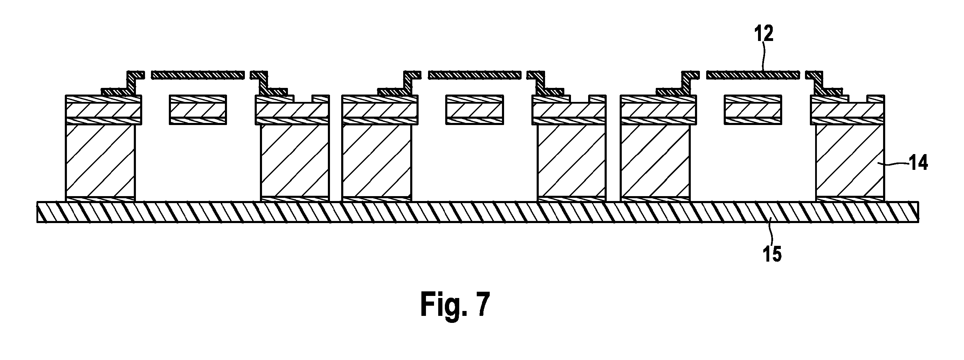

Fig. 7 zeigt eine schematische Querschnittsansicht des erfindungsgemäßen Schutzsystems aus Fig. 6 nach dem rückstandsfreien Entfernen der Schutzschicht 10.
Abschließend kann der Verbund aus vereinzelten Wafern 14 mit der Sägefolie 15 und der Polymer-Schutzschicht 10 nach dem Sägen derart erhitzt und/oder bestrahlt werden, dass sich das Polymer vollständig und rückstandsfrei zersetzt. Die Zersetzung erfolgt typischerweise bei Temperaturen um 200°C. Besonders vorteilhaft kann der gesägte Wafer 14 mit der Polymerschicht auf der Sägefolie 15 belichtet werden. Die Polymere zersetzen sich dann bereits bei deutlich geringeren Temperaturen um ca. 100°C. Die Sägefolie 15 wird dabei nicht beschädigt.
Im Anschluss daran kann die Sägefolie 15 beispielsweise zunächst expandiert werden, so dass die Einzelstrukturen mit größerem Abstand angeordnet sind. Dies vereinfacht das nachfolgende Abpicken von der Sägefolie 15, was zum Beispiel mit Pick-and-Place-Tools ausgeführt werden kann. Die Einzelstrukturen können abschließend verpackt und weiterverarbeitet werden.

## Patentansprüche

1. Schutzsystem für MEMS-Strukturen, mit
einer fragilen offenen Struktur (12) und einer optionalen Opferschicht (13), aufgebracht auf einem Wafer (14),
**dadurch gekennzeichnet, dass**
eine Schutzschicht (10) auf der Vorderseite der Struktur (12) aufgebracht ist, wobei die Schutzschicht (10) rückstandsfrei entfernbar ist.

2. Schutzsystem nach Anspruch 1 **dadurch gekennzeichnet, dass** die fragile offene Struktur (12) eine Membran ist.

3. Schutzsystem nach Anspruch 1 oder 2 **dadurch gekennzeichnet, dass** die Schutzschicht (10) ein Polymer umfasst, das thermisch und/oder mittels Strahlung zersetzbar ist.

4. Schutzsystem nach Anspruch 1, 2 oder 3 **dadurch gekennzeichnet, dass** die Schutzschicht (10) ein Polynorbonen oder ein Polycarbonat umfasst.

5. Verfahren zur Prozessierung von fragilen offenen MEMS-Strukturen, **gekennzeichnet durch** die Schritte
a) Aufbringen einer Schutzschicht (10) auf die Vorderseite einer fragilen offenen Struktur (12),
b) Durchführung von Rückseitenprozessen,
c) gegebenenfalls Ätzen einer optionalen Opferschicht (13) und Freistellen der Struktur (10) von der Rückseite her, und
d) rückstandsfreies Entfernen der Schutzschicht (10).

6. Verfahren nach Anspruch 5, **dadurch gekennzeichnet, dass** nach Schritt c) als weitere Schritte
e) Aufbringen eines Wafers (14) auf eine Sägefolie (15), und
f) Sägen des Wafers (14) von der Vorderseite,
ausgeführt werden.

7. Verfahren nach Anspruch 5 oder 6 **dadurch gekennzeichnet, dass** die Schutzschicht (10) durch Aufschleudern eines flüssigen, thermisch und/oder mittels Strahlung zersetzbaren Polymers aufgebracht wird.

8. Verfahren nach einem der Ansprüche 5 bis 7 **dadurch gekennzeichnet, dass** die Schutzschicht (10) bei Temperaturen zwischen 80°C und 450°C, bevorzugt bei Temperaturen zwischen 100°C und 250°C, rückstandsfrei entfernt wird.

9. Verfahren nach einem der Ansprüche 5 bis 8 **dadurch gekennzeichnet, dass** als Plasma-Rückseiten-Prozesse Tieftrench und/oder Oxidöffnen durchgeführt werden.

10. Verfahren nach einem der Ansprüche 5 bis 9 **dadurch gekennzeichnet, dass** die Opferschicht (13) eine SiGe- oder Oxid-Schicht ist und die SiGe-Schicht mit ClF₃-Gas und die Oxid-Schicht mit HF-Dampf geätzt wird.

11. Verfahren nach einem der Ansprüche 5 bis 10 **dadurch gekennzeichnet, dass** die Sägefolie (15) im Anschluss an Schritt f) expandiert wird.

12. Verwendung eines Schutzsystems nach einem der Ansprüche 1 bis 4 für die Herstellung mikromechanischer Bauteile mit fragilen offenen MEMS-Strukturen, insbesondere zur Herstellung kapazitiver Mikrophone.
